# EUROPEAN PATENT APPLICATION

(11) **EP 3 926 694 A1**
(43) Date of publication of application: **22.12.2021**
(21) Application number: 20773410.4
(22) Date of filing: 27.02.2020
(51) Int. Cl.: H01L 31/05, H01L 31/044, H02S 40/36, H02S 40/38

(54) **PHOTOVOLTAIC ASSEMBLY**

(30) Priority: 20.03.2019 CN 201910213436; 20.03.2019 CN 201910213440; 20.03.2019 CN 201910213452
(71) Applicant: Longi Green Energy Technology Co., Ltd., Xi'an, Shaanxi 710100 (CN)
(72) Inventor: XU, Qingfeng, Xi'an, Shaanxi 710100 (CN); XU, Chen, Xi'an, Shaanxi 710100 (CN); WANG, Le, Xi'an, Shaanxi 710100 (CN); HE, Bingxuan, Xi'an, Shaanxi 710100 (CN)
(74) Representative: Loo, Chi Ching
(86) International application number: PCT/CN2020/076929
(87) International publication number: WO 2020/186987

(57) **Abstract**

The present application provides a photovoltaic assembly, and relates to the technical field of solar energy. The photovoltaic assembly includes at least one cell unit, and the cell unit is rectangular; the cell unit includes a plurality of cell-string groups that are electrically connected, each of the cell-string groups includes a plurality of cell strings that are connected in parallel, and each of the cell strings includes a plurality of cell that are connected in series; each of the cell-string groups has two electrically conductive ends and two side edges located between the two electrically conductive ends; and at least two neighboring instances of the cell-string groups are arranged in a predetermined mode, wherein the predetermined mode is that: one of the electrically conductive ends of one of the cell-string groups and one of the side edges of the neighboring cell-string group are located on a same straight line, and the two neighboring cell-string groups are located at a same side of the straight line. The photovoltaic assembly according to the present application can reduce the consumption of the bus bars that are provided specially for reversely connecting in parallel the diodes, to save the bus bars.

## Description

The present application claims the priority of the Chinese patent applications filed on March 20th, 2019 before the Chinese Patent Office with the application numbers of 201910213436.1, 201910213440.8 and 201910213452.0 and the title of "PHOTOVOLTAIC ASSEMBLY", which are incorporated herein in their entirety by reference.

### TECHNICAL FIELD

The present application relates to the technical field of solar energy, and particularly relates to a photovoltaic assembly.

### BACKGROUND

Photovoltaic assemblies are devices that convert light energy into electric energy by using the photovoltaic effect. In photovoltaic assemblies, it is usually required to connect in series a plurality of cell, to form a cell string, and a plurality of the cell strings may be connected in series or connected in parallel into a cell-string group. In operation, if a cell is blocked (by a tree shade, dust, bird manure and so on), the blocked cell will become a load, consume the power generated by the other cell, and generate heat, to cause the increase of the local temperature of the assembly, result in the hot-spot effect, and cause the solar cell to have a lower output power or even be burnt down. In order to reduce the affection by the hot spot, it is usually required to introduce an diode into the photovoltaic assembly. The diode requires to be connected to the two ends of a cell string or cell-string group by a dedicated bus bar to be reversely connected in parallel to the cell string or cell-string group, and when the cell connected in parallel to the diode is blocked, the diode is turned on to enable the cell string or cell-string group where the blocked cell is located to be bypassed by the diode, to prevent the hot-spot effect. However, because of the cost and the limitation by the arrangement mode of the cell strings or cell-string groups, cases emerge that a plurality of cell strings or cell-string groups share one diode. Therefore, when one cell is blocked, the hot-spot effect happens and the diode is turned on, all of the cell strings or cell-string groups that share the diode are bypassed, and the power loss of the assembly is too large. In an ideal situation, each of the cell is reversely connected in parallel to one diode, and when one cell is blocked and the hot-spot effect happens, merely the blocked cell is bypassed by the diode, and the other cell, which normally operate, are not affected. However, if more diodes are to be introduced, the conventional arrangement modes of the cell strings or cell-string groups will result in a great increase of the consumption of the bus bars, and the arrangement of the bus bars will be very difficult.

It should be noted that the information disclosed in the section of BACKGROUND is merely intended to facilitate the comprehension on the background of the present application, and thus may contain information that is not the prior art known by a person skilled in the art.

### SUMMARY

A purpose of the present application is to provide a photovoltaic assembly, which can avoid increasing the consumption of the bus bars to a large extent while adding the bypass diodes, and facilitates wiring, to improve the capacity of the photovoltaic assembly of resisting hot spots.

According to an aspect of the present application, there is provided a photovoltaic assembly, wherein the photovoltaic assembly comprises at least one cell unit, and the cell unit is rectangular;
the cell unit comprises a plurality of cell-string groups that are electrically connected, each of the cell-string groups comprises a plurality of cell strings that are connected in parallel, and each of the cell strings comprises a plurality of cell that are connected in series;
each of the cell-string groups has two electrically conductive ends and two side edges located between the two electrically conductive ends; and
at least two neighboring instances of the cell-string groups are arranged in a predetermined mode, wherein the predetermined mode is that:
one of the electrically conductive ends of one of the cell-string groups and one of the side edges of the neighboring cell-string group are located on a same straight line, and the two neighboring cell-string groups are located at a same side of the straight line.

Optionally, the cell unit comprises a first cell-string group, a second cell-string group and a third cell-string group;
both of the second cell-string group and the third cell-string group are adjacent to the first cell-string group;
one of electrically conductive ends of the first cell-string group and one of side edges of the second cell-string group are located on a first straight line, and the first cell-string group and the second cell-string group are located at a same side of the first straight line; and
one of electrically conductive ends of the third cell-string group and one of side edges of the first cell-string group are located on a second straight line, and the third cell-string group and the first cell-string group are located at a same side of the second straight line.

Optionally, the cell unit further comprises a fourth cell-string group, both of the second cell-string group and the third cell-string group are adjacent to the fourth cell-string group, and the third cell-string group is electrically connected to the fourth cell-string group;
one of the side edges of the third cell-string group and one of the electrically conductive ends of the fourth cell-string group are located on a third straight line, and the third cell-string group and the fourth cell-string group are located at a same side of the third straight line; and
one of the electrically conductive ends of the second cell-string group and one of the side edges of the fourth cell-string group are located on a fourth straight line, and the second cell-string group and the fourth cell-string group are located at a same side of the fourth straight line.

Optionally, a length of the side edges of the first cell-string group is equal to a length of the electrically conductive ends of the second cell-string group.

Optionally, a length of the side edges of the first cell-string group is greater than a length of the electrically conductive ends of the second cell-string group.

Optionally, the first cell-string group, the second cell-string group, the third cell-string group and the fourth cell-string group have a same shape.

Optionally, the cell unit comprises a first cell-string group, a second cell-string group and a third cell-string group;
both of the second cell-string group and the third cell-string group are adjacent to the first cell-string group, and are located at a same side edge of the first cell-string group;
one of electrically conductive ends of the first cell-string group and one of side edges of the second cell-string group are located on a first straight line, and the first cell-string group and the second cell-string group are located at a same side of the first straight line; and
the other of the electrically conductive ends of the first cell-string group and one of the side edges of the third cell-string group are located on a second straight line, and the first cell-string group and the third cell-string group are located at a same side of the second straight line.

Optionally, the cell unit further comprises a fourth cell-string group, both of the second cell-string group and the third cell-string group are adjacent to the fourth cell-string group, and the third cell-string group is electrically connected to the fourth cell-string group;
one of the electrically conductive ends of the fourth cell-string group and one of the side edges of the second cell-string group are located on the first straight line, and the fourth cell-string group and the second cell-string group are located at a same side of the first straight line; and
the other of the electrically conductive ends of the fourth cell-string group and one of the side edges of the third cell-string group are located on the second straight line, and the fourth cell-string group and the third cell-string group are located at a same side of the second straight line.

Optionally, a length of the side edges of the first cell-string group is equal to a sum between a length of the electrically conductive ends of the second cell-string group and a length of the electrically conductive ends of the third cell-string group.

Optionally, a length of the side edges of the first cell-string group is greater than a sum between a length of the electrically conductive ends of the second cell-string group and a length of the electrically conductive ends of the third cell-string group.

Optionally, a diode is reversely connected in parallel between the electrically conductive ends of each of the cell-string groups; or
at least two neighboring instances of the cell-string groups are reversely connected in parallel to a same diode.

Optionally, the photovoltaic assembly further comprises a transparent cover plate covering a front face of the cell unit, a pattern marker is provided at a position on an inner side or outer side of the transparent cover plate that corresponds to a bus bar, and the bus bar electrically connects the electrically conductive ends of neighboring instances of the cell-string groups.

Optionally, the photovoltaic assembly further comprises a transparent cover plate covering a front face of the cell unit, a light emitting device is provided at a position of the transparent cover plate that corresponds to the bus bar, the light emitting device is located on an inner side or outer side of the transparent cover plate, and the bus bar electrically connects the electrically conductive ends of neighboring instances of the cell-string groups.

Optionally, the photovoltaic assembly further comprises a transparent cover plate covering a front face of the cell unit, the transparent cover plate is provided with a covering layer, an orthographic projection of a pattern of the covering layer on the cell unit matches with a bus bar, and the bus bar electrically connects the electrically conductive ends of neighboring instances of the cell-string groups.

Optionally, two neighboring instances of the cell of a same instance of the cell-string groups overlap, and are connect in series by a conductive adhesive or a wire.

Optionally, the photovoltaic assembly further comprises a junction box, and the diode is located inside the junction box; or
the diode is packaged inside the cell unit.

In the photovoltaic assembly according to the present application, in the cell-string groups of the rectangular cell unit, one of the electrically conductive ends of one of the cell-string groups and one of the side edges of the neighboring cell-string group are located on a same straight line, and the two neighboring cell-string groups are located at a same side of the straight line, whereby, when the electrically conductive ends of the two cell-string groups are connected by a bus bar, the bus bar can extend between the electrically conductive ends of the cell-string groups, and the extension part can at the same time be used to reversely connect in parallel a diode, thereby reducing the consumption of the bus bars that are provided specially for reversely connecting in parallel the diodes, to save the bus bars. Moreover, a diode may be reversely connected in parallel between the electrically conductive ends of each of the cell-string groups, which can increase the quantity of the diodes, to improve the capacity of the photovoltaic assembly of resisting hot spots. The blank region provided on the double-glass assembly may be used to place the junction box and the nameplate, thereby preventing blocking the cell, to eliminate the hot-spot effect.

It should be understood that the above general description and the following detailed description are merely exemplary and explanatory, and cannot limit the present application.

### BRIEF DESCRIPTION OF THE DRAWINGS

The drawings here are incorporated into the description and form part of the description. The drawings show the embodiments of the present application, and interpret the principle of the present application together with the description. Apparently, the figures that are described below are embodiments of the present application, and a person skilled in the art can obtain other figures according to these figures without paying creative work.
FIG. 1 is a schematic diagram of one of the cell strings of the photovoltaic assembly according to the present application.
FIG. 2 is a schematic diagram of the first embodiment of the photovoltaic assembly according to the present application.
FIG. 3 is a schematic diagram of the second embodiment and the third embodiment of the photovoltaic assembly according to the present application.
FIG. 4 is a schematic diagram of the fourth embodiment of the photovoltaic assembly according to the present application.
FIG. 5 is a schematic diagram of the fifth embodiment and the sixth embodiment of the photovoltaic assembly according to the present application.
FIG. 6 is a schematic diagram of the seventh embodiment of the photovoltaic assembly according to the present application.
FIG. 7 is a schematic diagram of the eighth embodiment of the photovoltaic assembly according to the present application.
FIG. 8 is a schematic diagram of the ninth embodiment of the photovoltaic assembly according to the present application.
FIG. 9 is a schematic diagram of the tenth embodiment and the eleventh embodiment of the photovoltaic assembly according to the present application.
FIG. 10 is a schematic diagram of the twelfth embodiment of the photovoltaic assembly according to the present application.
FIG. 11 is a schematic diagram of the thirteenth embodiment and the fourteenth embodiment of the photovoltaic assembly according to the present application.
FIG. 12 is a schematic diagram of the fifteenth embodiment of the photovoltaic assembly according to the present application.
FIG. 13 is a schematic diagram of the sixteenth embodiment of the photovoltaic assembly according to the present application.
FIG. 14 is a schematic diagram of the seventeenth embodiment of the photovoltaic assembly according to the present application.
FIG. 15 is a schematic diagram of the eighteenth embodiment of the photovoltaic assembly according to the present application.
FIG. 16 is a schematic diagram of the nineteenth embodiment of the photovoltaic assembly according to the present application.
FIG. 17 is a partial schematic diagram of the diodes in the sixth embodiment of the photovoltaic assembly according to the present application.
FIG. 18 is another partial schematic diagram of the diodes in the sixth embodiment of the photovoltaic assembly according to the present application.
FIG. 19 is a schematic diagram of the back face of the eleventh embodiment of the photovoltaic assembly according to the present application.
FIG. 20 is a schematic diagram of the back face of the eighth embodiment of the photovoltaic assembly according to the present application.
FIG. 21 is a schematic diagram of the back face of the seventh embodiment, the fifteenth embodiment and the sixteenth embodiment of the photovoltaic assembly according to the present application.
FIG. 22 is a schematic diagram of the back face of the eighteenth embodiment of the photovoltaic assembly according to the present application.

In the drawings: 100: cell unit; 101: blank region; 200: cell string; 201: cell; 202: punched solder strips; 300: junction box; 400: nameplate; 1: first cell-string group; 2: second cell-string group; 3: third cell-string group; 4: fourth cell-string group; 5: fifth cell-string group; 6: sixth cell-string group; 7: first bus bar; 8: second bus bar; 9: third bus bar; 10: fourth bus bar; 11: first diode; 12: second diode; 13: third diode; and 14: fourth diode.

### DETAILED DESCRIPTION

The exemplary embodiments will be described in further detail now with reference to the drawings. However, the exemplary embodiments may be implemented in various forms, and should not be understood as limited to the embodiments stated herein. In contrast, those embodiments are provided to enable the present disclosure to be comprehensive and complete, and to fully convey the concept of the exemplary embodiments to a person skilled in the art. In the drawings, the same reference numbers represent the same or similar components, and therefore the detailed description on them are omitted.

Although the description uses terms of relativity, such as "upper" and "lower", to describe the relation between one component marked in the drawings with respect to another component, those terms are used in the description merely for convenience, for example, based on the exemplary directions in the drawings. It can be understood that, if the device marked in the drawings is reverted to make it upside down, then a component described as "upper" will become a "lower" component. When a certain component is "on" another component, the certain component may be integrally formed on the another component, or the certain component may be "directly" provided on the another component, or the certain component may be "indirectly" provided on the another component via another component. The terms "a", "an", "the", "said" and "at least one" are intended to indicate the existence of one or more elements, components and so on. The terms "comprise" and "have" are intended to indicate opened inclusions and refer to that, other than the listed elements, components and so on, additional elements, components and so on may exist.

The embodiments of the present application provide a photovoltaic assembly, wherein the photovoltaic assembly comprises at least one cell unit, and the cell unit is rectangular; the cell unit comprises a plurality of cell-string groups that are electrically connected, each of the cell-string groups comprises a plurality of cell strings that are connected in parallel, and each of the cell strings comprises a plurality of cell that are connected in series; each of the cell-string groups has two electrically conductive ends and two side edges located between the two electrically conductive ends; and at least two neighboring instances of the cell-string groups are arranged in a predetermined mode, wherein the predetermined mode is that: one of the electrically conductive ends of one of the cell-string groups and one of the side edges of the neighboring cell-string group are located on a same straight line, and the two neighboring cell-string groups are located at a same side of the straight line.

In the photovoltaic assembly according to the embodiments of the present application, in the cell-string groups of the rectangular cell unit, one of the electrically conductive ends of one of the cell-string groups and one of the side edges of the neighboring cell-string group are located on a same straight line, and the two neighboring cell-string groups are located at a same side of the straight line, whereby, when the electrically conductive ends of the two cell-string groups are connected by a bus bar, the bus bar can extend between the electrically conductive ends of the cell-string groups, and the extension part can at the same time be used to reversely connect in parallel a diode, thereby reducing the consumption of the bus bars that are provided specially for reversely connecting in parallel the diodes, to save the bus bars.

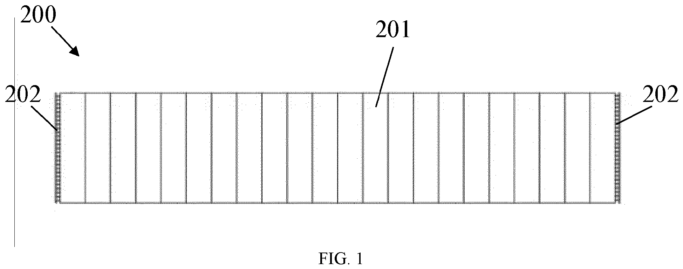

In a technical solution of the present application, rectangle is a regular shape, which facilitates splicing and arrangement. Therefore, and the cell unit is rectangular, which facilitates to splice a plurality of the cell units to form a photovoltaic system of a large area. As shown in FIG. 1, the cell string 200 may comprise a plurality of cell 201 that are sequentially connected in series, for example, comprising 2-35 cell 201. The cell 201 is the smallest module in the cell string for realizing photovoltaic conversion, and by connecting a plurality of the cell 201 in series to form the cell string, the electricity generation capacity can be increased. The type of the cell 201 is not particularly limited herein. In the same cell string 200, two neighboring cell 201 may overlap and may be connected in series by a conductive adhesive or a metal wire. Moreover, the cell string 200 may further comprise two punched solder strips 202, wherein one of the punched solder strips 202 is connected to the cathode of the cell string, and the other of the punched solder strips 202 is connected to the anode of the cell string. From the perspective of the manufacturing process, the gap of the punched solder strips provides a room for deformation, which can prevent the electrode failure caused by thermal expansion and contraction of the cell string during the manufacturing process. Each of the cell-string groups has two electrically conductive ends and two side edges, the two side edges are located between the two electrically conductive ends, and the two electrically conductive ends are the cathode and the anode of the cell-string groups. The cell-string groups may be of a rectangular shape, which include square and oblong. Furthermore, the shapes of the different cell-string groups may be the same or different. Furthermore, the sizes of the different cell-string groups may be the same or different. Each two neighboring cell-string groups have a gap therebetween, for a bus bar connecting the cell-string groups to pass through. Bus bars are individually provided at the two electrically conductive ends of the cell string. The bus bars are welded to the punched solder strips on the electrically conductive ends of the cell strings to connect at least two neighboring cell strings in parallel to form the cell-string group. Moreover, the neighboring cell-string groups are also connected in parallel or in series by bus bars. When the photovoltaic assembly is a double-glass double-face assembly, in order to prevent blocking of the back face of the cell unit by the junction box and the nameplate which results in a hot spot, the cell unit may have a blank region, so as to place the junction box and the nameplate on a transparent cover plate corresponding to the position of the blank region. The blank region is formed by enclosure of a plurality of cell-string groups. Certainly, the cell unit may not have the blank region.

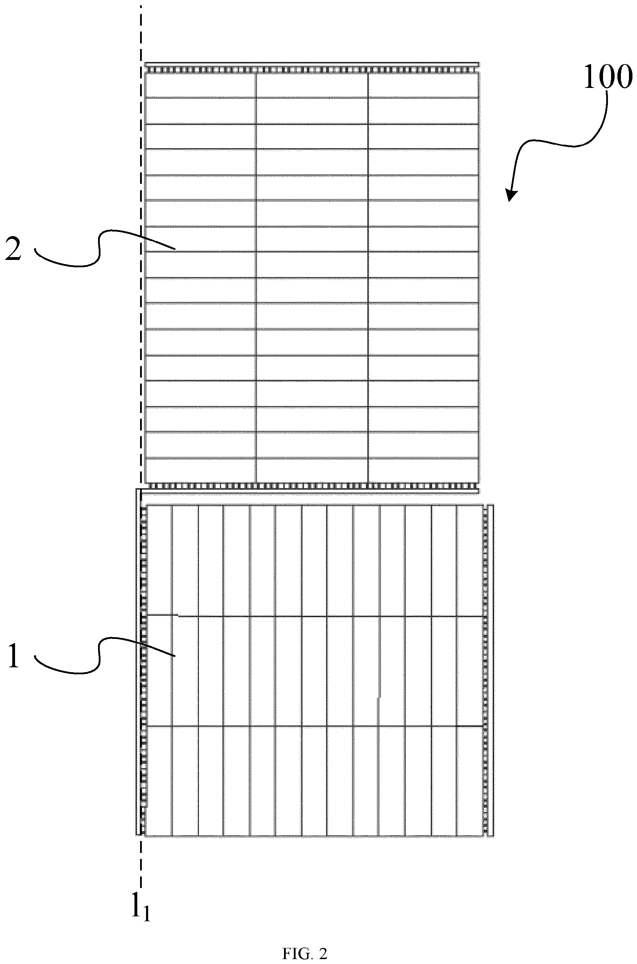

As the first embodiment of the photovoltaic assembly according to the present application, as shown in FIG. 2, a cell unit formed by two cell-string groups is taken as an example. The cell unit 100 comprises a first cell-string group 1 and a second cell-string group 2. The first cell-string group 1 and the second cell-string group 2 are adjacently spliced, one of the side edges of the first cell-string group 1 and one of the electrically conductive ends of the second cell-string group 2 are located on a first straight line l₁, and both of the first cell-string group 1 and the second cell-string group 2 are located on the same side of the first straight line l₁ (the right side of l₁ shown in FIG. 2). It can be understood that, in the arrangement mode shown in FIG. 2, the length of the side edges of the first cell-string group 1 and the length of the electrically conductive ends of the second cell-string group 2 are equal, whereby the cell unit 100 satisfies a rectangular shape. Therefore, in the photovoltaic assembly according to the embodiment of the present application, when the electrically conductive ends of two neighboring cell-string groups are connected by a bus bar, the bus bar can extend between the electrically conductive ends of the cell-string groups, and the extension part can at the same time be used to reversely connect in parallel a diode, thereby reducing the consumption of the bus bars that are provided specially for reversely connecting in parallel the diodes, to save the bus bars.

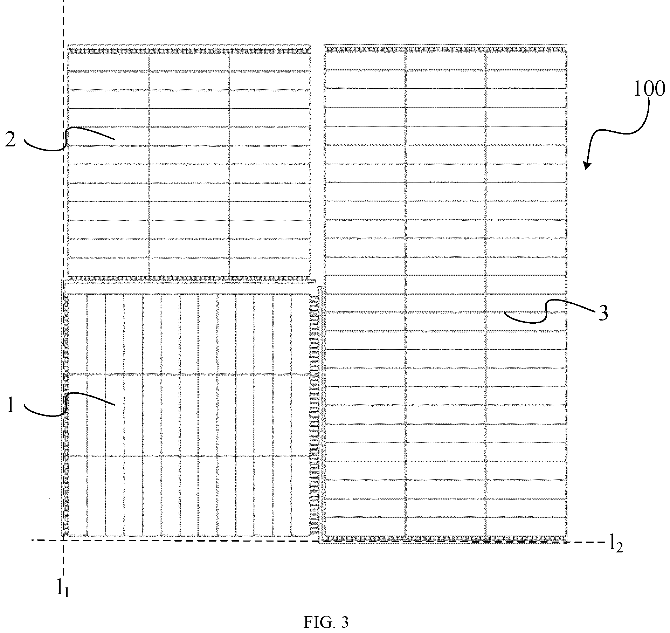

As the second embodiment of the photovoltaic assembly according to the present application, as shown in FIG. 3, on the basis of the first embodiment, a third cell-string group 3 may be added to form the cell unit 100. The first cell-string group 1 and the second cell-string group 2 are located on the same side of the first straight line l₁, and the third cell-string group 3 is adjacent to both of the first cell-string group 1 and the second cell-string group 2. In this case, the third cell-string group 3 and the first cell-string group 1 are still required to satisfy a position relation similar to that between the first cell-string group 1 and the second cell-string group 2; in other words, one of the electrically conductive ends of the third cell-string group 3 and one of the side edges of the first cell-string group 1 are located on a second straight line l₂, and the third cell-string group 3 and the first cell-string group 1 are located on the same side of the second straight line l₂ (the upper side of l₂ shown in FIG. 3).

It can be understood that, in order to ensure that the cell unit is still of a rectangular shape, the length of the side edges of the third cell-string group 3 is equal to the sum between the length of the electrically conductive ends of the first cell-string group 1 and the length of the side edges of the second cell-string group 2. Therefore, such a cell unit comprising three cell-string groups can be used to splice into the photovoltaic assembly, the advantages of which may refer to the first embodiment, and are not discussed here further.

As the third embodiment of the photovoltaic assembly according to the present application, as shown in FIG. 3, on the basis of the second embodiment, when the length of the side edges of the first cell-string group 1 is equal to the length of the electrically conductive ends of the second cell-string group 2, one of the side edges of the first cell-string group 1 and one of the electrically conductive ends of the second cell-string group 2 are aligned on the first straight line l₁. It can be easily understood that, in this case, the cell unit 100 formed by three cell-string groups does not have the blank region, which can prevent waste of the planar area.

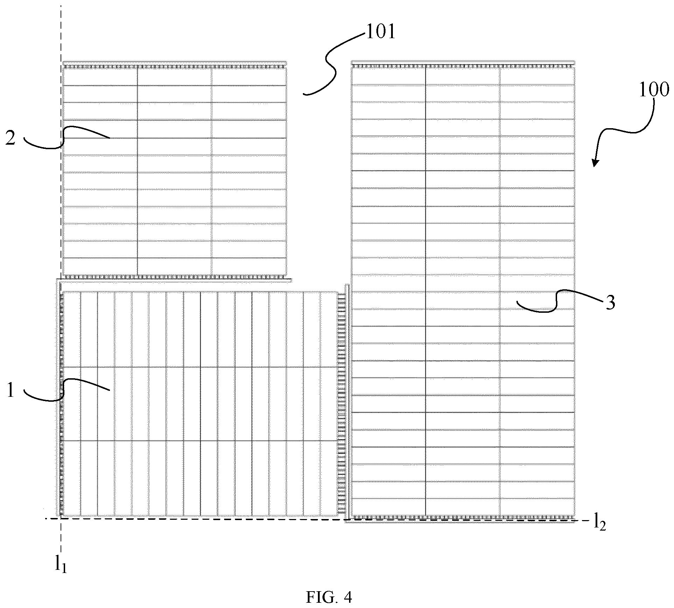

As the fourth embodiment of the photovoltaic assembly according to the present application, as shown in FIG. 4, on the basis of the second embodiment, when the length of the side edges of the first cell-string group 1 is greater than the length of the electrically conductive ends of the second cell-string group 2, along the first straight line l₁, one of the side edges of the first cell-string group 1 goes beyond one of the electrically conductive ends of the second cell-string group 2. It can be easily understood that, in this case, by adding the third cell-string group 3, the cell unit 100 formed by three cell-string groups has the blank region 101. Such a cell unit 100 is particularly suitable for a double-glass double-face assembly, and the junction box and the nameplate may be placed at the blank region, to prevent blocking of the back face of the cell unit by the junction box and the nameplate which results in a hot spot.

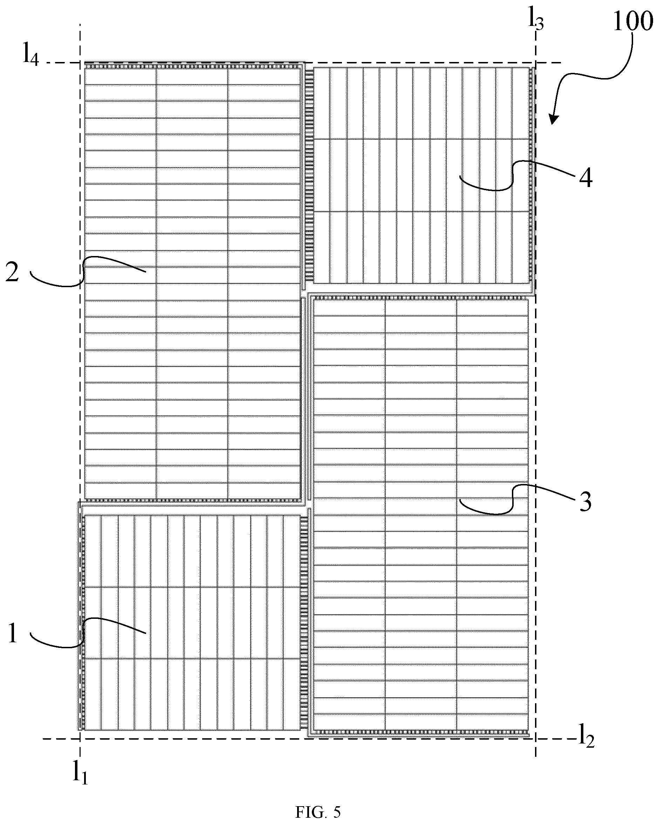

As the fifth embodiment of the photovoltaic assembly according to the present application, as shown in FIG. 5, on the basis of the second embodiment, a fourth cell-string group 4 may be added to form the cell unit 100. The first cell-string group 1 and the second cell-string group 2 are located on the same side of the first straight line l₁, and the third cell-string group 3 is adjacent to both of the first cell-string group 1 and the second cell-string group 2. One of the electrically conductive ends of the third cell-string group 3 and one of the side edges of the first cell-string group 1 are located on a second straight line l₂, and the third cell-string group 3 and the first cell-string group 1 are located on the same side of the second straight line h. In this case, the fourth cell-string group 4 and the third cell-string group 3 are still required to satisfy a position relation similar to that between the first cell-string group 1 and the second cell-string group 2; in other words, one of the side edges of the third cell-string group 3 and one of the electrically conductive ends of the fourth cell-string group 4 are located on a third straight line l₃, and the third cell-string group 3 and the fourth cell-string group 4 are located on the same side of the third straight line l₃ (the left side of l₃ shown in FIG. 5). Furthermore, in order to ensure that the cell unit 100 is of a rectangular shape, one of the electrically conductive ends of the second cell-string group 2 and one of the side edges of the fourth cell-string group 4 are located on a fourth straight line l₄, and the second cell-string group 2 and the fourth cell-string group 4 are located on the same side of the fourth straight line l₄ (the lower side of l₄ shown in FIG. 5). Therefore, such a cell unit comprising four cell-string groups can be used to splice into the photovoltaic assembly, the advantages of which may refer to the first embodiment, and are not discussed here further.

As the sixth embodiment of the photovoltaic assembly according to the present application, as shown in FIG. 5, on the basis of the fifth embodiment, when the length of the side edges of the first cell-string group 1 is equal to the length of the electrically conductive ends of the second cell-string group 2, one of the side edges of the first cell-string group 1 and one of the electrically conductive ends of the second cell-string group 2 are aligned on the first straight line l₁. It can be easily understood that, in this case, the cell unit 100 formed by four cell-string groups does not have the blank region, which can prevent waste of the planar area.

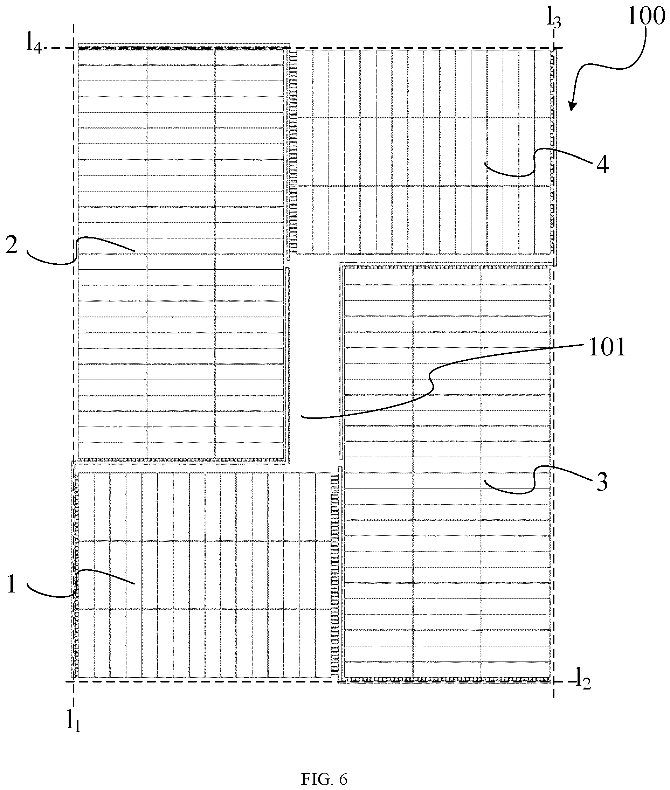

As the seventh embodiment of the photovoltaic assembly according to the present application, as shown in FIG. 6, on the basis of the fifth embodiment, when the length of the side edges of the first cell-string group 1 is greater than the length of the electrically conductive ends of the second cell-string group 2, along the first straight line l₁, one of the side edges of the first cell-string group 1 goes beyond one of the electrically conductive ends of the second cell-string group 2. It can be easily understood that, in this case, by adding the third cell-string group 3 and the fourth cell-string group 4, the cell unit 100 formed by four cell-string groups has the blank region 101. Such a cell unit 100 is particularly suitable for a double-glass double-face assembly, and the junction box and the nameplate may be placed at the blank region, to prevent blocking of the back face of the cell unit by the junction box and the nameplate which results in a hot spot.

On the basis of the fifth embodiment, the first cell-string group 1, the second cell-string group 2, the third cell-string group 3 and the fourth cell-string group 4 have the same shape.

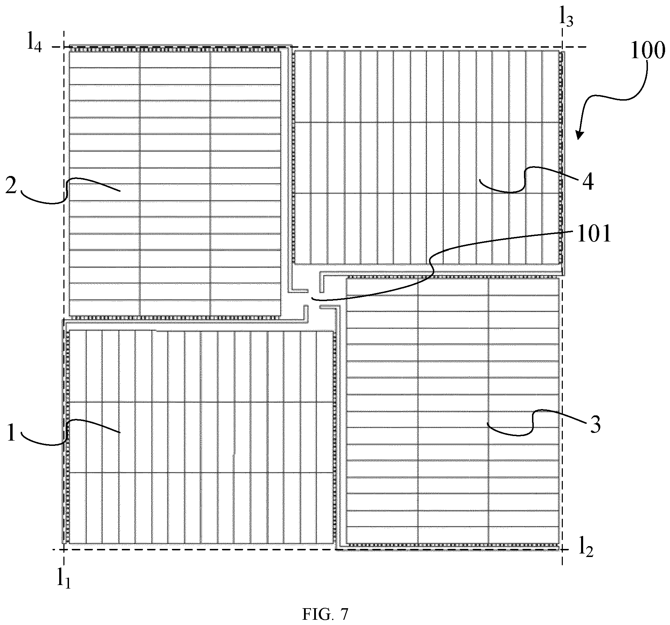

It can be easily understood that, when all of the first cell-string group 1, the second cell-string group 2, the third cell-string group 3 and the fourth cell-string group 4 are oblong, the eighth embodiment of the photovoltaic assembly according to the present application shown in FIG. 7 may be formed, wherein the cell unit 100 has the blank region 101.

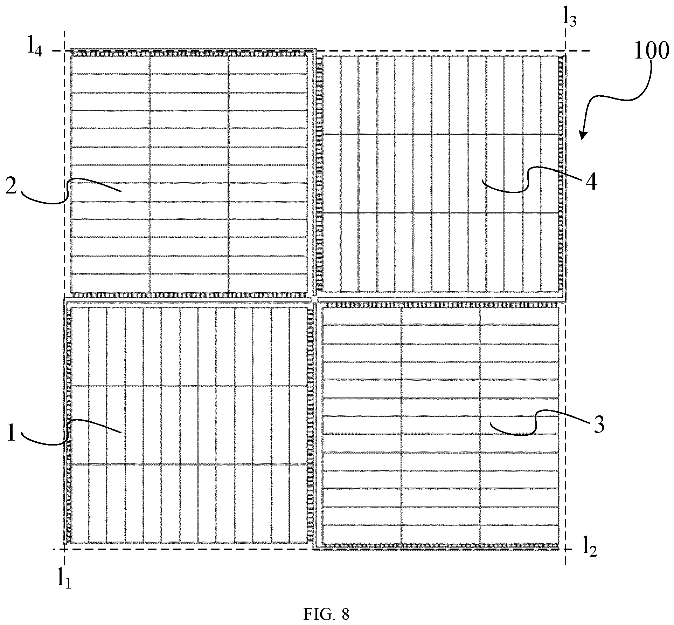

When all of the first cell-string group 1, the second cell-string group 2, the third cell-string group 3 and the fourth cell-string group 4 are square, the ninth embodiment of the photovoltaic assembly according to the present application shown in FIG. 8 may be formed, wherein the cell unit 100 does not have the blank region. It should be noted that, because the bus bars are arranged at the edge positions of the cell-string groups according to the present embodiment, that the shape of the cell-string groups is square does not mean that it is an absolutely standard square, but it is an approximate square. If the difference between the lengths of two neighboring side edges of the cell-string groups satisfies the arrangement of the bus bars, that satisfies the square shape according to the present embodiment.

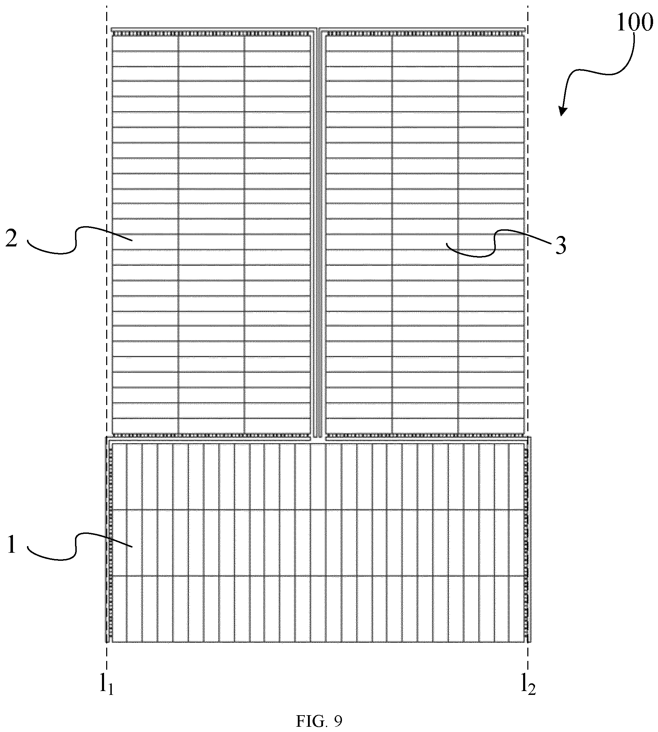

As the tenth embodiment of the photovoltaic assembly according to the present application, as shown in FIG. 9, on the basis of the first embodiment, a third cell-string group 3 may be added to form the cell unit 100. Both of the second cell-string group 2 and the third cell-string group 3 are adjacent to the first cell-string group 1, and are located on the same side edge of the first cell-string group 1 (the upper side of the first cell-string group 1 shown in FIG. 9). The first cell-string group 1 and the second cell-string group 2 are located on the same side of the first straight line l₁ (the right side of l₁ shown in FIG. 9), and the third cell-string group 3 is adjacent to both of the first cell-string group 1 and the second cell-string group 2. In this case, one of the side edges of the third cell-string group 3 and the other of the electrically conductive ends of the first cell-string group 1 are located on the second straight line l₂, and the third cell-string group 3 and the first cell-string group 1 are located on the same side of the second straight line l₂ (the left side of l₂ shown in FIG. 9).

It can be understood that, in order to ensure that the cell unit is still of a rectangular shape, the length of the side edges of the third cell-string group 3 is equal to the length of the side edges of the second cell-string group 2. Therefore, such a cell unit comprising three cell-string groups can be used to splice into the photovoltaic assembly, the advantages of which may refer to the first embodiment, and are not discussed here further.

As the eleventh embodiment of the photovoltaic assembly according to the present application, as shown in FIG. 9, on the basis of the ninth embodiment, when the length of the side edges of the first cell-string group 1 is equal to the sum between the length of the electrically conductive ends of the second cell-string group 2 and the length of the electrically conductive ends of the third cell-string group 3, it can be easily understood that, in this case, the cell unit 100 formed by three cell-string groups does not have the blank region, which can prevent waste of the planar area.

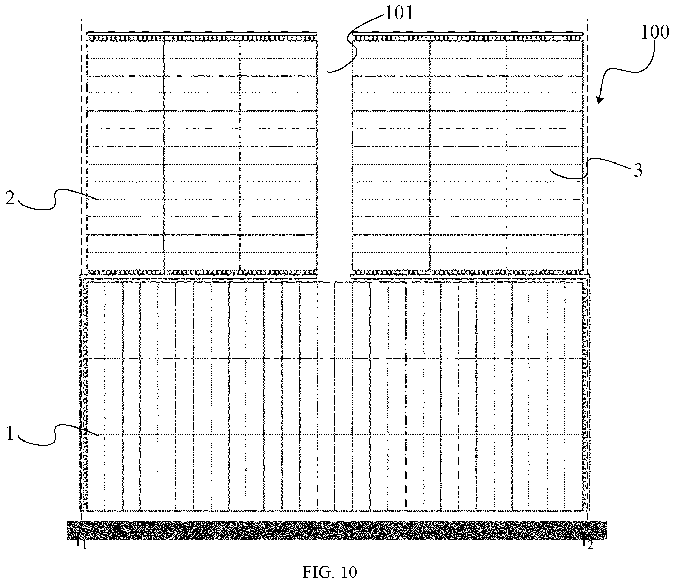

As the twelfth embodiment of the photovoltaic assembly according to the present application, as shown in FIG. 10, on the basis of the tenth embodiment, when the length of the side edges of the first cell-string group 1 is greater than the sum between the length of the electrically conductive ends of the second cell-string group 2 and the length of the electrically conductive ends of the third cell-string group 3, it can be easily understood that, in this case, the cell unit 100 formed by three cell-string groups has the blank region 101. Such a cell unit 100 is particularly suitable for a double-glass double-face assembly, and the junction box and the nameplate may be placed at the blank region, to prevent blocking of the back face of the cell unit by the junction box and the nameplate which results in a hot spot.

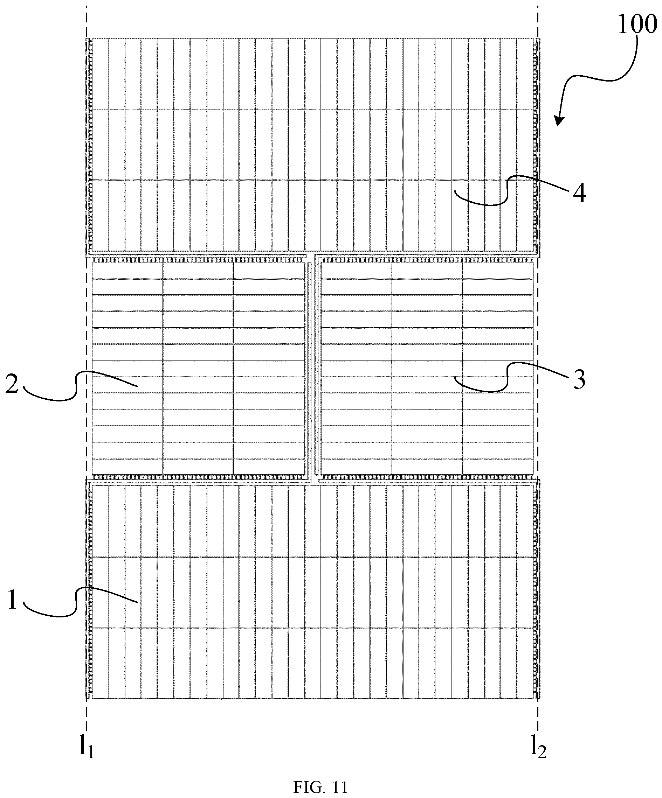

As the thirteenth embodiment of the photovoltaic assembly according to the present application, as shown in FIG. 11, on the basis of the tenth embodiment, a fourth cell-string group 4 may be added to form the cell unit 100. The first cell-string group 1 and the second cell-string group 2 are located on the same side of the first straight line l₁ (the right side of l₁ shown in FIG. 11), and the third cell-string group 3 is adjacent to both of the first cell-string group 1 and the second cell-string group 2. One of the side edges of the third cell-string group 3 and the other of the electrically conductive ends of the first cell-string group 1 are located on the second straight line l₂, and the second cell-string group 2 and the third cell-string group 3 are located on the same side edge of the first cell-string group 1 (the upper side of the first cell-string group 1 shown in FIG. 11). In this case, the fourth cell-string group 4 and the first cell-string group 1 are in the form of a symmetrical arrangement. In other words, both of the second cell-string group 2 and the third cell-string group 3 are adjacent to the fourth cell-string group 4, and are located on the same side edge of the fourth cell-string group 4 (the lower side of the fourth cell-string group 4 shown in FIG. 11); one of the electrically conductive ends of the fourth cell-string group 4 and one of the side edges of the second cell-string group 2 are located on the first straight line l₁, and the fourth cell-string group 4 and the second cell-string group 2 are located on the same side of the first straight line l₁ (the right side of l₁ shown in FIG. 11); and the other of the electrically conductive ends of the fourth cell-string group 4 and one of the side edges of the third cell-string group 3 are located on the second straight line l₂, and the fourth cell-string group 4 and the third cell-string group 3 are located on the same side of the second straight line l₂ (the left side of l₂ shown in FIG. 11). Therefore, such a cell unit comprising four cell-string groups can be used to splice into the photovoltaic assembly, the advantages of which may refer to the first embodiment, and are not discussed here further.

As the fourteenth embodiment of the photovoltaic assembly according to the present application, as shown in FIG. 11, on the basis of the thirteenth embodiment, when the length of the side edges of the first cell-string group 1 is equal to the sum between the length of the electrically conductive ends of the second cell-string group 2 and the length of the electrically conductive ends of the third cell-string group 3, it can be easily understood that, in this case, the cell unit 100 formed by four cell-string groups does not have the blank region, which can prevent waste of the planar area.

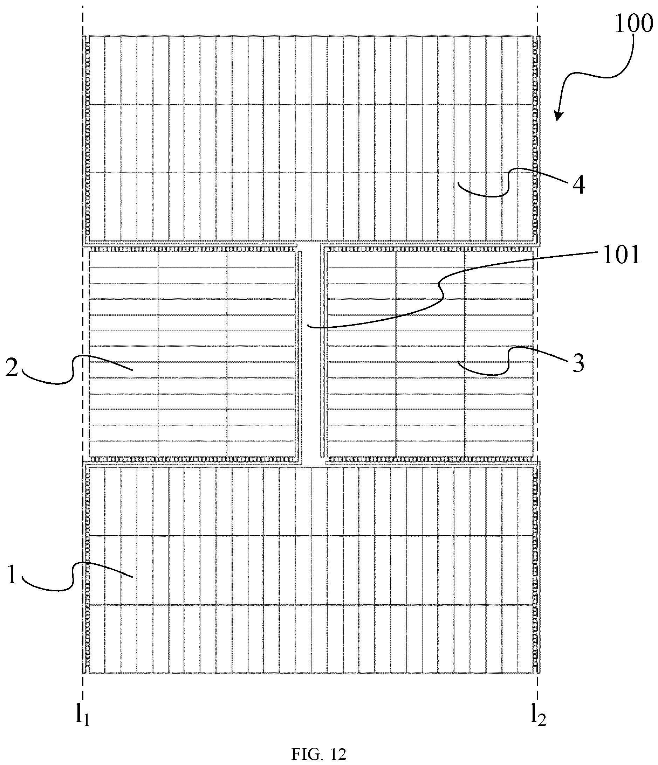

As the fifteenth embodiment of the photovoltaic assembly according to the present application, as shown in FIG. 12, on the basis of the thirteenth embodiment, when the length of the side edges of the first cell-string group 1 is greater than the sum between the length of the electrically conductive ends of the second cell-string group 2 and the length of the electrically conductive ends of the third cell-string group 3, it can be easily understood that, in this case, the cell unit 100 formed by four cell-string groups has the blank region 101. Such a cell unit 100 is particularly suitable for a double-glass double-face assembly, and the junction box and the nameplate may be placed at the blank region, to prevent blocking of the back face of the cell unit by the junction box and the nameplate which results in a hot spot.

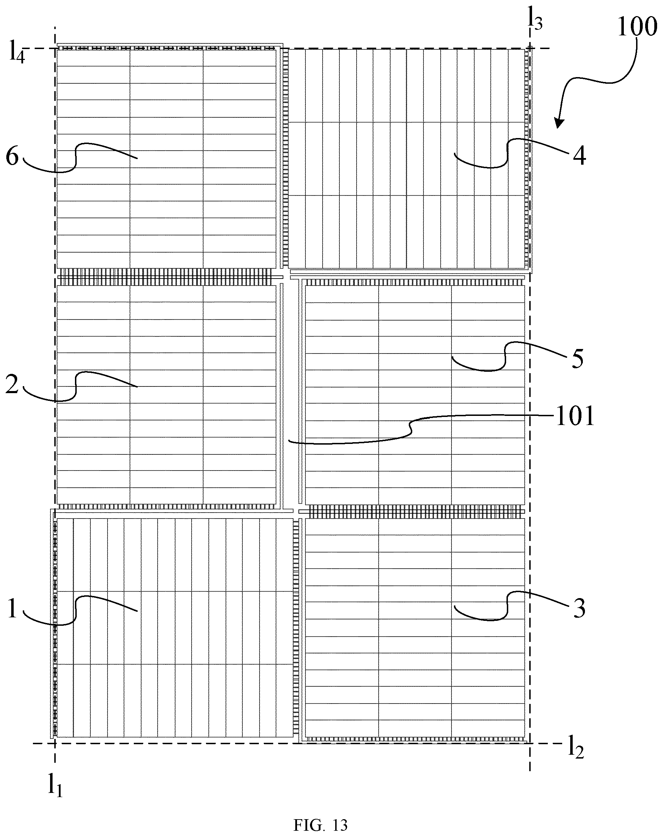

As the sixteenth embodiment of the photovoltaic assembly according to the present application, as shown in FIG. 13, the cell unit 100 comprises a first cell-string group 1, a second cell-string group 2, a third cell-string group 3, a fourth cell-string group 4, a fifth cell-string group 5 and a sixth cell-string group 6. The first cell-string group 1 is adjacent to the second cell-string group 2, one of the electrically conductive ends of the first cell-string group 1 and one of the side edges of the second cell-string group 2 are located on a first straight line l₁, and the first cell-string group 1 and the second cell-string group 2 are located on the right side of the first straight line l₁. The third cell-string group 3 is adjacent to the first cell-string group 1, one of the electrically conductive ends of the third cell-string group 3 and one of the side edges of the first cell-string group 1 are located on a second straight line l₂, and the third cell-string group 3 and the first cell-string group 1 are located on the upper side of the second straight line h. The fourth cell-string group 4 and the first cell-string group 1 are centrosymmetric with respect to the center of the cell unit 100, the fifth cell-string group 5 and the second cell-string group 2 are centrosymmetric with respect to the center of the cell unit 100, and the sixth cell-string group 6 and the third cell-string group 3 are centrosymmetric with respect to the center of the cell unit 100. In other words, the fifth cell-string group 5 and the sixth cell-string group 6 are individually adjacent to the fourth cell-string group 4, and one of the side edges of the fifth cell-string group 5 and one of the electrically conductive ends of the fourth cell-string group 4 are located on a third straight line l₃; at the same time, the fifth cell-string group 5 is further adjacent to the third cell-string group 3, one of the side edges of the fifth cell-string group 5 and one of the side edges of the third cell-string group 3 are located on the third straight line l₃, and all of the fifth cell-string group 5, the fourth cell-string group 4 and the third cell-string group 3 are located on the left of the third straight line l₃. One of the electrically conductive ends of the sixth cell-string group 6 and one of the side edges of the fourth cell-string group 4 are located on a fourth straight line l₄, and the sixth cell-string group 6 and the fourth cell-string group 4 are located on the lower side of the fourth straight line 14; at the same time, the sixth cell-string group 6 is further adjacent to the second cell-string group 2, one of the side edges of the sixth cell-string group 6 is adjacent to one of the side edges of the second cell-string group 2, and all of the sixth cell-string group 6, the second cell-string group 2 and the first cell-string group 1 are located on the right side of the first straight line l₁.

It can be understood that, in order to ensure that the cell unit is still of a rectangular shape, and in order to satisfy the arrangement mode of centrosymmetry of the cell unit 100, the fourth cell-string group 4 and the first cell-string group 1 have the same shapes and sizes, the fifth cell-string group 5 and the second cell-string group 2 have the same shapes and sizes, and the sixth cell-string group 6 and the third cell-string group 3 have the same shapes and sizes. In the present embodiment, the length of the side edges of the first cell-string group 1 is greater than the length of the electrically conductive ends of the second cell-string group 2, and, correspondingly, the length of the side edges of the fourth cell-string group 4 is greater than the length of the electrically conductive ends of the fifth cell-string group 5. It can be easily understood that, in this case, the cell unit 100 formed by six cell-string groups has the blank region, and the junction box and the nameplate may be placed at the blank region, to prevent blocking of the back face of the cell unit by the junction box and the nameplate which results in a hot spot. The cell unit 100 also has the advantageous effects of the first embodiment.

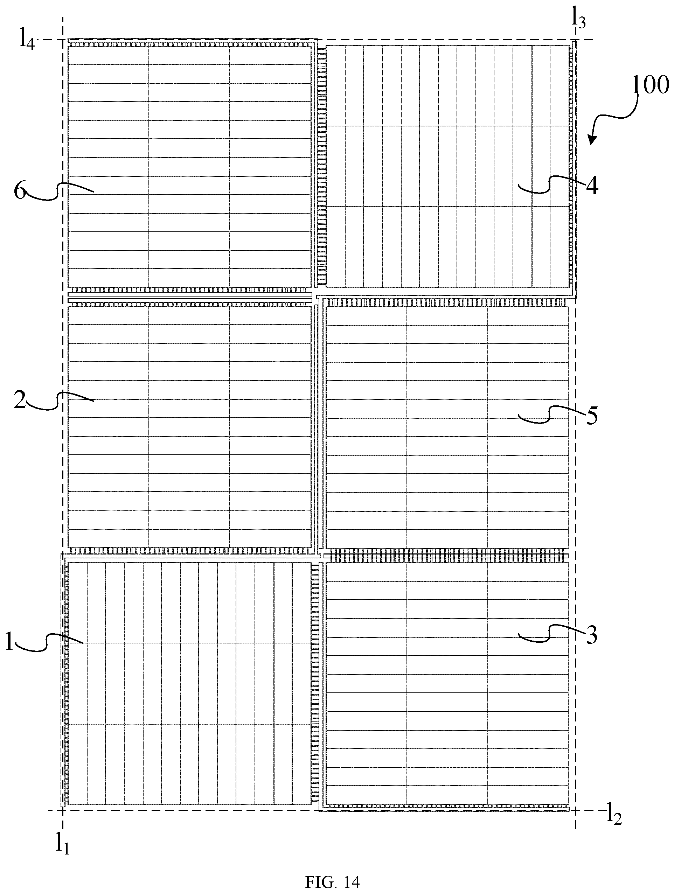

As the seventeenth embodiment of the photovoltaic assembly according to the present application, as shown in FIG. 14, the quantity and the distribution mode of the cell-string groups of the cell unit 100 are the same as those of the sixteenth embodiment. In that cell unit, in an aspect, it may be designed that the lengths of the electrically conductive ends of the second cell-string group 2 and the fifth cell-string group 5 are equal to the lengths of the side edges of the first cell-string group 1 and the fourth cell-string group 4, whereby the cell unit 100 does not have the blank region. Because the cell unit 100 also employs the arrangement mode of centrosymmetry, in another aspect, it may also be designed that the sum between the lengths of the electrically conductive ends of the second cell-string group 2 and the fifth cell-string group 5 is equal to the sum between one of the side edges of the first cell-string group 1 and one of the electrically conductive ends of the third cell-string group 3, to form the cell unit 100 that does not have the blank region.

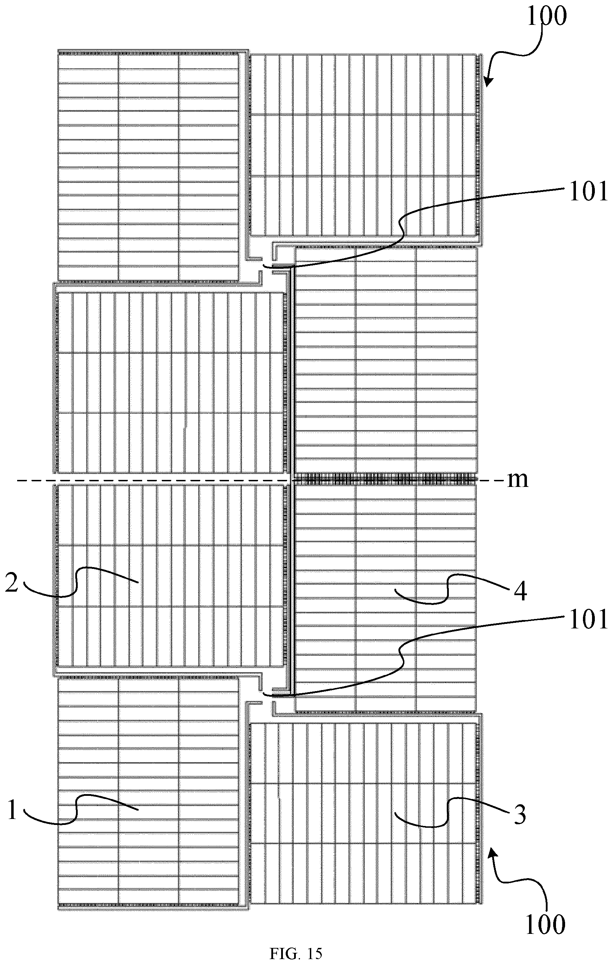

As the eighteenth embodiment of the photovoltaic assembly according to the present application, as shown in FIG. 15, the photovoltaic assembly comprises two cell units 100 that are distributed rectangularly, and the two cell units 100 are distributed symmetrically with respect to a straight line therebetween. The cell units 100 may be cell units 100 that have the blank region. For example, FIG. 15 provides an example in which the cell units 100 are the cell unit 100 according to the eighth embodiment, whereby the photovoltaic assembly has two blank regions 101. In practical implementations, the cell units 100 may also be the cell unit 100 that has the blank region according to the other embodiments such as FIG. 6, which is not limited in the present disclosure.

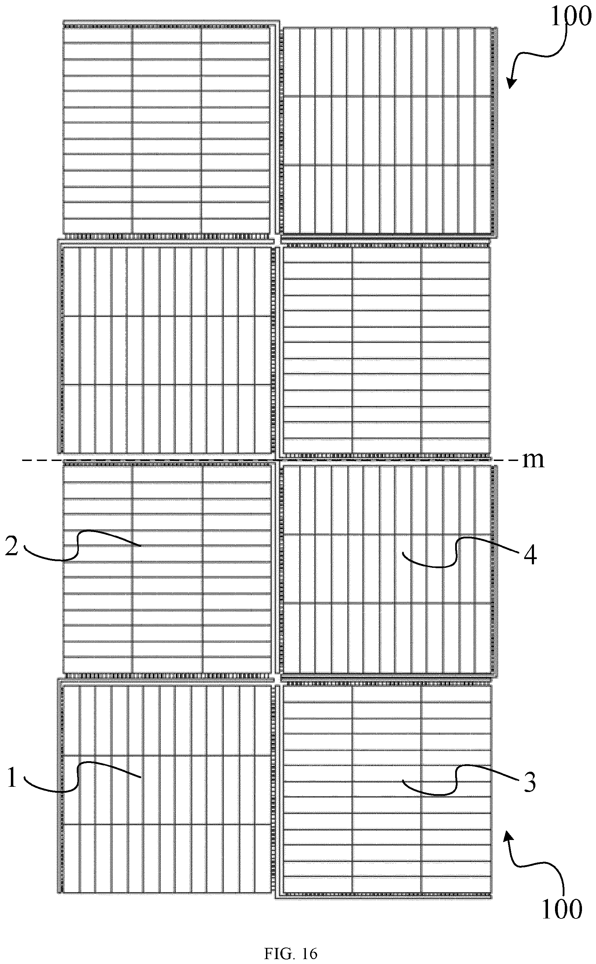

As the nineteenth embodiment of the photovoltaic assembly according to the present application, as shown in FIG. 16, the photovoltaic assembly comprises two cell units 100 that are distributed rectangularly, and the two cell units 100 are distributed symmetrically with respect to a straight line therebetween. The cell units 100 may be cell units 100 that do not have the blank region. For example, FIG. 16 provides an example in which the cell units 100 are the cell unit 100 according to the ninth embodiment, whereby the photovoltaic assembly does not have the blank region. In practical implementations, the cell units 100 may also be the cell unit 100 that does not have the blank region according to the other embodiments such as FIG. 5, which is not limited in the present disclosure.

Moreover, it should be noted that, by comprehensively considering the eighteenth embodiment and the nineteenth embodiment, a combined mode may also be employed. In other words, the photovoltaic assembly comprises two cell units 100 that are distributed rectangularly, wherein one of the cell units 100 is the cell unit 100 that has the blank region (for example, the cell unit 100 according to the eighth embodiment), and the other of the cell units 100 is the cell unit 100 that does not have the blank region (for example, the cell unit 100 according to the ninth embodiment). The sizes of the two cell units are merely required to satisfy the condition that they can be spliced into a rectangle, and are not limited in the present disclosure. Therefore, a blank region can be formed in the photovoltaic assembly.

In the photovoltaic assemblies based on any one of the above embodiments, a diode may be reversely connected in parallel between the electrically conductive ends of each of the cell-string groups, thereby increasing the quantity of the diodes, to improve the capacity of the assembly of resisting hot spots. Certainly, one diode may also be reversely connected in parallel with a plurality of cell-string groups; for example, at least two neighboring instances of the cell-string groups are reversely connected in parallel to a same diode.

It should be noted that, in the cell units according to any one of the above embodiments, the modes of the electric connection between the cell-string groups may be, according to demands, series connection, firstly series connection and subsequently parallel connection, or firstly parallel connection and subsequently series connection.

The cell unit formed by four cell-string groups shown in FIG. 5 is taken as an example. When the four cell-string groups are sequentially connected in series, the first mode may be that the fourth cell-string group 4, the second cell-string group 2, the first cell-string group 1 and the third cell-string group 3 are head-tail connected (in other words, one of the electrically conductive ends of the preceding one cell-string group is electrically connected to one of the electrically conductive ends of the subsequent one cell-string group), the spare electrically conductive end of the fourth cell-string group 4 is used as the cathode, and the spare electrically conductive end of the third cell-string group 3 is used as the anode, wherein each of the cell-string groups is reversely connected in parallel to one diode. The second mode may be that the fourth cell-string group 4, the second cell-string group 2, the first cell-string group 1 and the third cell-string group 3 are head-tail connected, the spare electrically conductive end of the fourth cell-string group 4 is used as the cathode, and the spare electrically conductive end of the third cell-string group 3 is used as the anode, wherein one diode is reversely connected in parallel between the fourth cell-string group 4 and the second cell-string group 2, the fourth cell-string group 4 and the second cell-string group 2 share the same diode, one diode is reversely connected in parallel between the first cell-string group 1 and the third cell-string group 3, and the first cell-string group 1 and the third cell-string group 3 share the same diode. The third mode may be that the second cell-string group 2, the first cell-string group 1, the third cell-string group 3 and the fourth cell-string group 4 are head-tail connected, the spare electrically conductive end of the second cell-string group 2 is used as the cathode, and the spare electrically conductive end of the fourth cell-string group 4 is used as the anode, wherein each of the cell-string groups is reversely connected in parallel to one diode. The fourth mode may be that the second cell-string group 2, the first cell-string group 1, the third cell-string group 3 and the fourth cell-string group 4 are head-tail connected, the spare electrically conductive end of the second cell-string group 2 is used as the cathode, and the spare electrically conductive end of the fourth cell-string group 4 is used as the anode, wherein one diode is reversely connected in parallel between the second cell-string group 2 and the first cell-string group 1, the second cell-string group 2 and the first cell-string group 1 share the same diode, one diode is reversely connected in parallel between the third cell-string group 3 and the fourth cell-string group 4, and the third cell-string group 3 and the fourth cell-string group 4 share the same diode. Certainly, the series connection may follow other sequences, which may refer to the above description by analogy, and is not discussed further. It should be noted that the cathode and anode defined in the above description are merely considered as one mode, and it can be understood that, in practical implementations, the cathode and the anode are relative, the positions of the electrodes may be exchanged, and the connection directions of the diodes may be adaptively adjusted. When the four cell-string groups are firstly connected in series and subsequently connected in parallel, the first mode may be that the fourth cell-string group 4 is connected in series to the second cell-string group 2, the first cell-string group 1 is connected in series to the third cell-string group 3, then the two strings are connected in parallel, one electrically conductive end of the fourth cell-string group 4 that is connected in parallel to the third cell-string group 3 is used as the cathode, and one electrically conductive end of the first cell-string group 1 that is connected in parallel to the second cell-string group 2 is used as the anode, wherein each of the cell-string groups is reversely connected in parallel to one diode. The second mode may be that the fourth cell-string group 4 is connected in series to the third cell-string group 3, the first cell-string group 1 is connected in series to the second cell-string group 2, then the two strings are connected in parallel, one electrically conductive end of the second cell-string group 2 that is connected in parallel to the fourth cell-string group 4 is used as the cathode, and one electrically conductive end of the third cell-string group 3 that is connected in parallel to the first cell-string group 1 is used as the anode, wherein each of the cell-string groups is reversely connected in parallel to one diode. It can be understood that, as compared with the first mode, it is merely required to adaptively adjust the connection directions of the diodes. Certainly, the mode of firstly series connection and subsequently parallel connection may follow other sequences, which may refer to the above description by analogy, and is not discussed further. It should be noted that the cathode and anode defined in the above description are merely considered as one mode, and it can be understood that, in practical implementations, the cathode and the anode are relative, the positions of the electrodes may be exchanged, and the connection directions of the diodes may be adaptively adjusted. In the solution of firstly series connection and subsequently parallel connection, as compared with conventional solutions, three diodes can be added, which facilitates to improve the performance of resisting hot spots of the photovoltaic assembly.

When the four cell-string groups are firstly connected in parallel and subsequently connected in series, the first mode may be that the fourth cell-string group 4 is connected in parallel to the second cell-string group 2, the fourth cell-string group 4 and the second cell-string group 2 share the same diode, the first cell-string group 1 is connected in parallel to the third cell-string group 3, the first cell-string group 1 and the third cell-string group 3 share the same diode, then the two sets are connected in series, and, after the series connection, the two spare ends are individually used as the cathode and the anode. The second mode may be that the fourth cell-string group 4 is connected in parallel to the third cell-string group 3, the fourth cell-string group 4 and the third cell-string group 3 share the same diode, the first cell-string group 1 is connected in parallel to the second cell-string group 2, the first cell-string group 1 and the second cell-string group 2 share the same diode, then the two sets are connected in series, and, after the series connection, the two spare ends are individually used as the cathode and the anode. Certainly, the mode of firstly parallel connection and subsequently series connection may follow other sequences, which may refer to the above description by analogy, and is not discussed further. In the solution of firstly parallel connection and subsequently series connection, as compared with conventional solutions, one diode can be added, which facilitates to improve the performance of resisting hot spots of the photovoltaic assembly.

Other modes of the electric connection between the cell-string groups in the cell unit may refer to the above-described connection modes, with adaptive modifications and adjustments, and are not discussed here further.

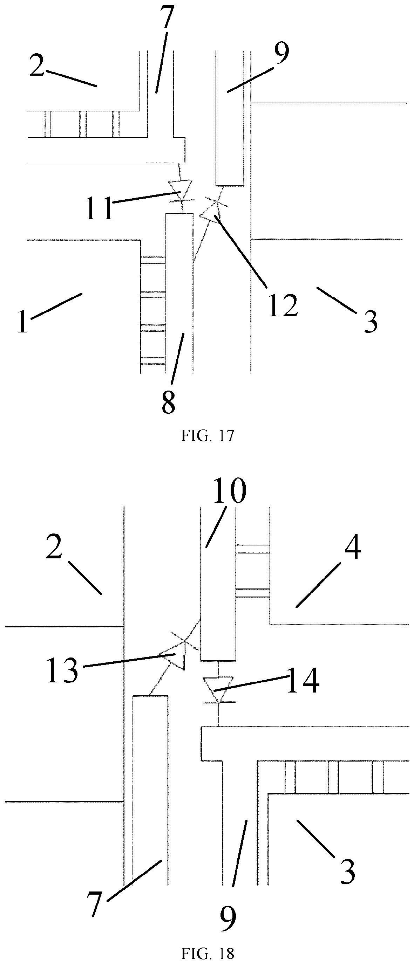

As an example, regarding the sixth embodiment, as shown in FIGS. 17 and 18, the first cell-string group 1 and the second cell-string group 2 may be connected by a first bus bar 7, the first cell-string group 1 and the third cell-string group 3 may be connected by a second bus bar 8, the third cell-string group 3 and the fourth cell-string group 4 may be connected by a third bus bar 9, and the fourth cell-string group 4 and the second cell-string group 2 may be connected by a fourth bus bar 10. A first diode 11 is connected between the first bus bar 7 and the second bus bar 8, a second diode 12 is connected between the second bus bar 8 and the third bus bar 9, a third diode 13 is connected between the first bus bar 7 and the fourth bus bar 10, and a fourth diode 14 is connected between the third bus bar 9 and the fourth bus bar 10.

The photovoltaic assembly may further comprise a junction box 300, and the diodes may be located inside the junction box 300. Regarding the cell unit 100 that has the blank region, the junction box 300 may be located at the blank region. Certainly, the diodes may also be directly connected to the bus bars, and packaged inside the cell unit 100.

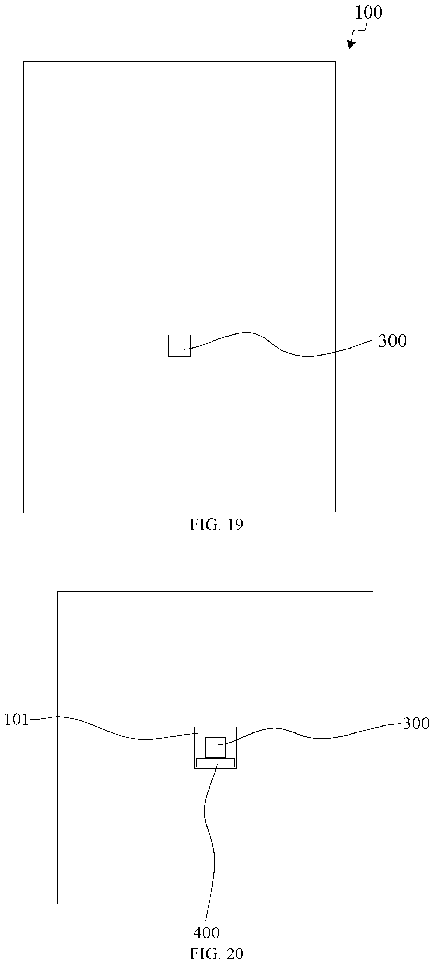

As shown in FIG. 19, FIG. 19 shows the back face of the eleventh embodiment of the photovoltaic assembly (see FIG. 9), wherein the junction box 300 is provided at the back face of the cell unit 100.

As shown in FIG. 20, FIG. 20 shows the back face of the eighth embodiment of the photovoltaic assembly (see FIG. 7), wherein the junction box 300 and a nameplate 400 may be provided within the blank region 101, the quantity of the junction box 300 is one, and all of the diodes are located inside the junction box 300.

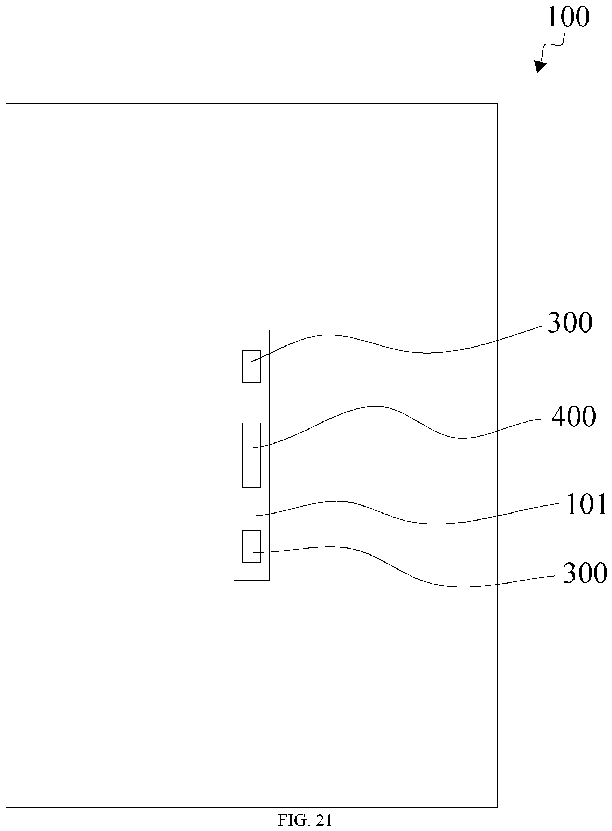

As shown in FIG. 21, FIG. 21 shows the back face of the seventh embodiment (see FIG. 6), the fifteenth embodiment (see FIG. 12) and the sixteenth embodiment (see FIG. 13) of the photovoltaic assembly. In the fourteenth, seventh and fifteenth embodiments, the junction box 300 and a nameplate 400 may be provided within the blank region 101. The quantity of the junction box 300 is two, the diodes are located individually inside the two junction boxes 300, and the two junction boxes 300 are located at the two side edges of the nameplate 400.

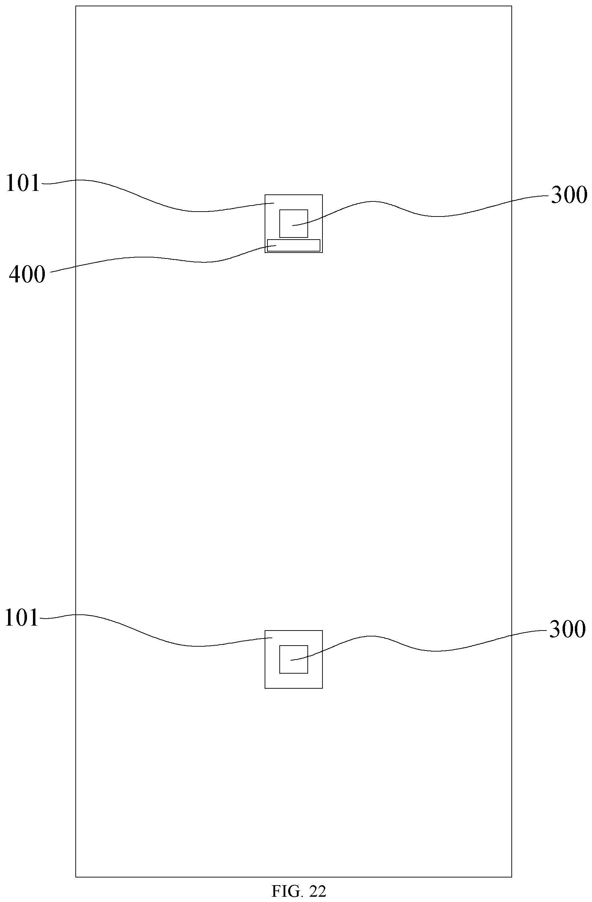

As shown in FIG. 22, FIG. 22 shows the back face of the eighteenth embodiment of the photovoltaic assembly (see FIG. 15). In the eighteenth embodiment, the photovoltaic assembly comprises two blank regions 101, and the junction box 300 and a nameplate 400 may be provided within each of the blank regions 101.

Regarding the above-described cell units according to the embodiments, the photovoltaic assembly according to the present application may further comprise a transparent cover plate, wherein the material of the transparent cover plate may be glass or other transparent materials. The transparent cover plate may cover one side of the cell unit, and a pattern marker may be provided at a position on the inner side or outer side of the transparent cover plate that corresponds to a bus bar, and the bus bar electrically connects the electrically conductive ends of neighboring instances of the cell-string groups. When the cell unit has the blank region 101, a pattern marker may be provided at a position on the inner side or outer side of the transparent cover plate that corresponds to the blank region 101. It should be noted that the position of the blank region 101 may refer to the region where the different bus bars, after extending, converge, and may also refer to the completely blank region in the region where the different bus bars, after extending, converge. The inner side of the transparent cover plate refers to the one side of the transparent cover plate that is closer to the cell unit, and the outer side of the transparent cover plate refers to the one side of the transparent cover plate that is further away from the cell unit. The particular structure of the pattern marker is not particularly limited herein. For example, the pattern marker may be an advertisement identifier that is fixed to the blank region by adhesion or in other manners, and so on.

In the above-described transparent cover plate, the transparent cover plate is provided with a light emitting device at the position corresponding to the blank region 101 or the bus bar, and the light emitting device is located on an inner side or outer side of the transparent cover plate. The light emitting device may be an LED lamp or other light emitting devices, as long as it can emit light. The color of the emitted light of the light emitting device is not particularly limited.

In an embodiment, the transparent cover plate covers the front face of the cell unit, the transparent cover plate is provided with a covering layer, and the orthographic projection of the pattern of the covering layer on the cell unit matches with the bus bar or the blank region 101, thereby masking the bus bar in the gap or the junction box in the blank region by using the covering layer. The material of the covering layer may be an enamel layer, and its color may be white, black, blue or other colors.

A person skilled in the art, after considering the description and implementing the invention disclosure herein, will readily envisage other embodiments of the present application. The present application aims at encompassing any variations, uses or adaptative alternations of the present application, wherein those variations, uses or adaptative alternations follow the general principle of the present application and include common knowledge or common technical means in the art that are not disclosed by the present application. The description and the embodiments are merely deemed as exemplary, and the true scope and spirit of the present application are presented by the appended claims.

## Claims

1. A photovoltaic assembly, wherein the photovoltaic assembly comprises at least one cell unit, and the cell unit is rectangular;
the cell unit comprises a plurality of cell-string groups that are electrically connected, each of the cell-string groups comprises a plurality of cell strings that are connected in parallel, and each of the cell strings comprises a plurality of cell that are connected in series;
each of the cell-string groups has two electrically conductive ends and two side edges located between the two electrically conductive ends; and
at least two neighboring instances of the cell-string groups are arranged in a predetermined mode, wherein the predetermined mode is that:
one of the electrically conductive ends of one of the cell-string groups and one of the side edges of the neighboring cell-string group are located on a same straight line, and the two neighboring cell-string groups are located at a same side of the straight line.

2. The photovoltaic assembly according to claim 1, wherein the cell unit comprises a first cell-string group, a second cell-string group and a third cell-string group;
both of the second cell-string group and the third cell-string group are adjacent to the first cell-string group;
one of electrically conductive ends of the first cell-string group and one of side edges of the second cell-string group are located on a first straight line, and the first cell-string group and the second cell-string group are located at a same side of the first straight line; and
one of electrically conductive ends of the third cell-string group and one of side edges of the first cell-string group are located on a second straight line, and the third cell-string group and the first cell-string group are located at a same side of the second straight line.

3. The photovoltaic assembly according to claim 2, wherein the cell unit further comprises a fourth cell-string group, both of the second cell-string group and the third cell-string group are adjacent to the fourth cell-string group, and the third cell-string group is electrically connected to the fourth cell-string group;
one of the side edges of the third cell-string group and one of the electrically conductive ends of the fourth cell-string group are located on a third straight line, and the third cell-string group and the fourth cell-string group are located at a same side of the third straight line; and
one of the electrically conductive ends of the second cell-string group and one of the side edges of the fourth cell-string group are located on a fourth straight line, and the second cell-string group and the fourth cell-string group are located at a same side of the fourth straight line.

4. The photovoltaic assembly according to claim 2 or 3, wherein
a length of the side edges of the first cell-string group is equal to a length of the electrically conductive ends of the second cell-string group.

5. The photovoltaic assembly according to claim 2 or 3, wherein
a length of the side edges of the first cell-string group is greater than a length of the electrically conductive ends of the second cell-string group.

6. The photovoltaic assembly according to claim 3, wherein the first cell-string group, the second cell-string group, the third cell-string group and the fourth cell-string group have a same shape.

7. The photovoltaic assembly according to claim 1, wherein the cell unit comprises a first cell-string group, a second cell-string group and a third cell-string group;
both of the second cell-string group and the third cell-string group are adjacent to the first cell-string group, and are located at a same side edge of the first cell-string group;
one of electrically conductive ends of the first cell-string group and one of side edges of the second cell-string group are located on a first straight line, and the first cell-string group and the second cell-string group are located at a same side of the first straight line; and
the other of the electrically conductive ends of the first cell-string group and one of the side edges of the third cell-string group are located on a second straight line, and the first cell-string group and the third cell-string group are located at a same side of the second straight line.

8. The photovoltaic assembly according to claim 7, wherein the cell unit further comprises a fourth cell-string group, both of the second cell-string group and the third cell-string group are adjacent to the fourth cell-string group, and the third cell-string group is electrically connected to the fourth cell-string group;
one of the electrically conductive ends of the fourth cell-string group and one of the side edges of the second cell-string group are located on the first straight line, and the fourth cell-string group and the second cell-string group are located at a same side of the first straight line; and
the other of the electrically conductive ends of the fourth cell-string group and one of the side edges of the third cell-string group are located on the second straight line, and the fourth cell-string group and the third cell-string group are located at a same side of the second straight line.

9. The photovoltaic assembly according to claim 7 or 8, wherein
a length of the side edges of the first cell-string group is equal to a sum between a length of the electrically conductive ends of the second cell-string group and a length of the electrically conductive ends of the third cell-string group.

10. The photovoltaic assembly according to claim 7 or 8, wherein
a length of the side edges of the first cell-string group is greater than a sum between a length of the electrically conductive ends of the second cell-string group and a length of the electrically conductive ends of the third cell-string group.

11. The photovoltaic assembly according to claim 1, wherein a diode is reversely connected in parallel between the electrically conductive ends of each of the cell-string groups; or
at least two neighboring instances of the cell-string groups are reversely connected in parallel to a same diode.

12. The photovoltaic assembly according to claim 1, wherein the photovoltaic assembly further comprises a transparent cover plate covering a front face of the cell unit, a pattern marker is provided at a position on an inner side or outer side of the transparent cover plate that corresponds to a bus bar, and the bus bar electrically connects the electrically conductive ends of neighboring instances of the cell-string groups.

13. The photovoltaic assembly according to claim 1, wherein the photovoltaic assembly further comprises a transparent cover plate covering a front face of the cell unit, a light emitting device is provided at a position of the transparent cover plate that corresponds to a bus bar, the light emitting device is located on an inner side or outer side of the transparent cover plate, and the bus bar electrically connects the electrically conductive ends of neighboring instances of the cell-string groups.

14. The photovoltaic assembly according to claim 1, wherein the photovoltaic assembly further comprises a transparent cover plate covering a front face of the cell unit, the transparent cover plate is provided with a covering layer, an orthographic projection of a pattern of the covering layer on the cell unit matches with a bus bar, and the bus bar electrically connects the electrically conductive ends of neighboring instances of the cell-string groups.

15. The photovoltaic assembly according to claim 14, wherein a color of the covering layer is white, black or blue.

16. The photovoltaic assembly according to claim 1, wherein two neighboring instances of the cell of a same instance of the cell-string groups overlap, and are connect in series by a conductive adhesive or a wire.

17. The photovoltaic assembly according to claim 11, wherein the photovoltaic assembly further comprises a junction box, and the diode is located inside the junction box; or
the diode is packaged inside the cell unit.
